# FASCICULE DE BREVET EUROPEEN

(11) **EP 1 955 433 B1**
(45) Date de publication et mention de la délivrance du brevet: **05.10.2016**
(21) Numéro de dépôt: 06831361.8
(22) Date de dépôt: 20.11.2006
(51) Int. Cl.: H02M 9/02, H02M 7/523, H02H 9/04

(54) **DISPOSITIF DE GENERATION DE PLASMA AVEC SUPPRESSION DES SURTENSIONS AUX BORNES DU TRANSISTOR DU GENERATEUR HAUTE TENSION PSEUDO CLASSE E**
PLASMAERZEUGUNGSEINRICHTUNG MIT ÜBERSPANNUNGSUNTERDRÜCKUNG AN DEN TRANSISTORANSCHLÜSSEN EINES HOCHSPANNUNGSGENERATORS DER PSEUDOKLASSE E
PLASMA GENERATING DEVICE WITH OVERVOLTAGE SUPPRESSION ON THE TRANSISTOR TERMINALS OF A HIGH-VOLTAGE PSEUDOCLASS E GENERATOR

(30) Priorité: 28.11.2005 FR 0512025
(43) Date de publication de la demande: 13.08.2008
(73) Titulaire: Renault s.a.s., 92100 Boulogne Billancourt (FR)
(72) Inventeur: AGNERAY, André, F-92100 Boulogne (FR); MALEK, Nadim, F-78000 Versailles (FR)
(86) Numéro de dépôt international: PCT/FR2006/051199
(87) Numéro de publication internationale: WO 2007/060362

(56) Documents cités:
- EP-A- 1 515 594
- DE-A1- 10 046 668
- US-A1- 2005 035 398
- US-B1- 6 348 716
- PATENT ABSTRACTS OF JAPAN vol. 008, no. 261 (E-281), 30 novembre 1984 (1984-11-30) -& JP 59 132673 A (NISSAN JIDOSHA KK), 30 juillet 1984 (1984-07-30)
- TIHANYI J: "PROTECTION OF POWER MOSFETS FROM TRANSIENT OVERVOLTAGES" SIEMENS FORSCHUNGS- UND ENTWICKLUNGSBERICHTE, SPRINGER VERLAG. BERLIN, DE, vol. 14, no. 2, 1985, pages 56-61, XP002047361 ISSN: 0370-9736

## Description

L'invention concerne les générateurs haute tension pseudo classe E, et plus particulièrement la suppression des surtensions aux bornes du transistor de commutation d'un tel générateur.

L'invention s'applique avantageusement mais non limitativement à la génération de plasma dans un gaz, utilisant de tels générateurs pseudo classe E, et notamment la génération de plasma utilisé pour l'allumage commandé pour moteur à combustion interne par les électrodes d'une bougie.

Le principe de la bougie résonante réside dans l'utilisation d'un ensemble résonant bobine-condensateur, ce dernier étant constitué par deux électrodes (dont l'une comporte le culot) séparées par un matériau diélectrique, tel que de la céramique. Ce résonateur haute fréquence est appelé généralement « bobine-bougie ». Ce résonateur est alimenté par un générateur de tension apte à délivrer un train d'impulsions de tension au résonateur en réponse à un train d'impulsions de commandes hautes fréquences reçues sur l'électrode de commande du transistor de commutation du générateur impulsionnel de tension.

Plus précisément, ce générateur impulsionnel comprend, outre le transistor de commutation commandé par le train haute fréquence d'impulsions de commande, un ensemble bobine-condensateur reliés en parallèle et alimentés par une moyenne tension.

La combinaison de ce générateur de tension impulsionnelle et du résonateur série (« bobine-bougie ») est couramment appelée par l'homme du métier « amplificateur pseudo classe E ».

Comme indiqué ci-avant, la commande du transistor de commutation s'effectue par une tension haute fréquence (train d'impulsions de commande) appliquée sur la grille du transistor. Lorsque le transistor est passant, un courant circule dans la bobine tandis que lorsque le transistor est bloqué, le courant charge d'une part le condensateur et d'autre part alimente la bobine du résonateur série. Le potentiel de drain du transistor s'élève. Cette tension élevée alimente périodiquement le résonateur série (bobine-bougie) qui, grâce à un facteur de qualité important, crée la haute tension capable de déclencher les étincelles.

Cela étant, un tel montage nécessite une commande du transistor de commutation par un train d'impulsions défini très précisément.

Plus précisément, les commandes de commutation du transistor doivent être précisément phasées avec la fréquence propre du résonateur série (bobine-bougie). Sans cela, on crée sur le drain du transistor de commutation des surtensions qui peuvent être destructrices pour ce composant. C'est particulièrement le cas à la fin de la première phase de mise en conduction du transistor si celle-ci est de même durée que les suivantes.

Aussi, une solution, décrite dans la demande de brevet européen n° 1 515 594 au nom de la demanderesse, consiste à réaliser une électronique telle que la première demi période soit deux fois plus courte que les autres.

Cependant, si le résonateur série (bobine-bougie) n'est pas exactement piloté à sa fréquence propre de résonance ou si, pour une raison quelconque, il n'y a pas eu d'étincelle haute tension, alors, à la fin du train de commande du transistor, l'énergie réactive emmagasinée dans le résonateur série va créer une surtension qui peut détruire le transistor.

L'invention vise à apporter une solution radicalement différente à ces problèmes.

Un but de l'invention est de proposer une solution qui ne fasse pas intervenir de stratégie élaborée de commande et de gestion de durée de la première impulsion.

Selon un aspect de l'invention, il est proposé un dispositif de génération de plasma comprenant une bougie de génération de plasma contenant un résonateur inductif capacitif apte à produire une haute tension, des moyens de génération d'un train d'impulsions de commande haute fréquence, et un générateur de tension comprenant un transistor de commutation dont l'électrode de commande est reliée à la sortie des moyens de génération du train d'impulsions de commande. Le générateur de tension comprend également une sortie apte à délivrer un train d'impulsions de tension au résonateur en réponse au train d'impulsions de commande reçues sur l'électrode de commande du transistor de commutation.

Selon une caractéristique générale de cet aspect de l'invention, il est prévu en outre des moyens connectés entre les deux électrodes de conduction du transistor de commutation et aptes à limiter la différence de tension entre ces deux électrodes.

Ces moyens de limitation de tension comprennent avantageusement une diode Zener.

Les moyens de génération du train d'impulsions de commande comprennent par ailleurs avantageusement un oscillateur à fréquence fixe. En effet, étant donné qu'il n'est plus nécessaire selon l'invention de prévoir une stratégie élaborée de commande du transistor de commutation, il devient possible d'utiliser un simple oscillateur à fréquence fixe, bien moins coûteux.

D'autres avantages et caractéristiques de l'invention apparaîtront à l'examen de la description détaillée de modes de réalisation, nullement limitatifs, et des dessins annexés sur lesquels :
- la figure 1 illustre de manière schématique un mode de réalisation d'un dispositif selon l'invention, et.
- la figure 2 illustre plus en détail un exemple de réalisation électronique d'un dispositif selon l'invention.

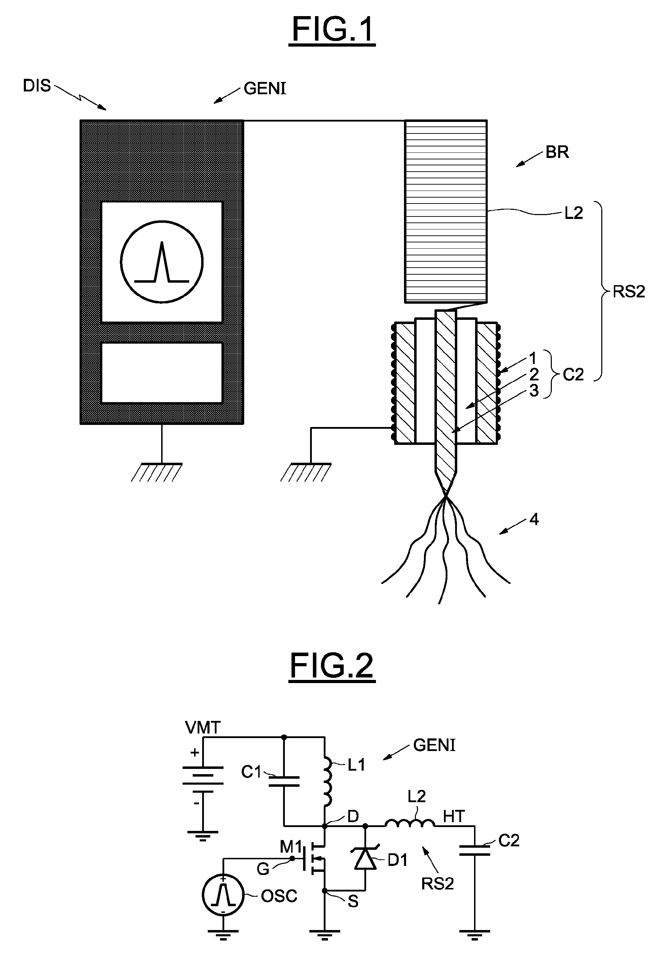

Sur la figure 1, la référence DIS désigne un dispositif de génération de plasma comprenant une bougie de génération de plasma résonante BR et un générateur de tension impulsionnelle périodique GENI.

La structure d'une bougie résonante BR est classique et connue en soi par l'homme du métier ainsi, des modes de réalisation d'une telle bougie sont par exemple décrits dans les demandes de brevets européens n°1 515 594 et 1 515 408 au nom de la demanderesse.

Plus précisément, comme illustré de façon schématique sur la figure 1, la bougie résonante BR comporte un ensemble résonant RS2. comportant une bobine inductive L2 et un condensateur C2 qui, dans l'exemple décrit ici est constitué par l'ensemble culot 1 - céramique 2 - électrode centrale 3. Le culot, formant l'autre électrode, est relié à la masse.

Ce résonateur haute tension RS2 est également appelé bobine-bougie.

Ce résonateur est alimenté par le générateur périodique d'impulsions GENI.

Comme illustré sur la figure 2, ce générateur impulsionnel de tension GENI comporte un ensemble bobine L1 et condensateur C1 reliés en parallèle, ainsi qu'un transistor de commutation M1, formé ici d'un transistor MOSFET de puissance à canal P, commandé sur sa grille G par un train d'impulsions de commande générées ici par un oscillateur à fréquence fixe. Cette fréquence est une haute fréquence, typiquement de l'ordre de quelques MHz et supérieure à 1 MHz.

La fréquence propre du résonateur série L2C2 présente également une fréquence de résonance élevée, par exemple supérieure à 1MHz, avec un facteur de surtension compris par exemple entre 40 et 200.

Le générateur impulsionnel GENI est alimenté par une source de tension VMT délivrant une moyenne tension, typiquement inférieure à 1 000 volt.

Par ailleurs, cette source de tension V MT présente de préférence une puissance limitée de façon à ce que l'énergie appliquée entre les électrodes de la bougie soit également limitée, par exemple à 300 mJ par allumage et pour des raisons de sécurité. Pour générer des tensions continues supérieures à 12 volt dans une application automobile, on peut utiliser un convertisseur 12 volt vers Y volt Y étant la tension fournie par l'alimentation VMT. On peut ainsi générer le niveau de tension continue souhaitée à partir d'une tension de batterie.

La stabilité de la tension continue générée n'étant a priori pas un critère déterminant, on peut à titre d'exemple, prévoir d'utiliser une alimentation à découpage pour alimenter le générateur GENI, pour ses qualités de robustesse et de simplicité.

Lorsque le transistor M1 est passant, un courant circule dans la bobine L1. Lorsque le transistor M1 est bloqué le courant charge d'une part le condensateur C1 et alimente la bobine L2.

Le potentiel de drain D du transistor M1 s'élève.

Cette tension élevée, typiquement de l'ordre de 500V alimente périodiquement le résonateur série RS2, qui grâce à un facteur de surtension important, crée la haute tension HT capable de déclencher les étincelles.

De façon à ne pas créer sur le drain du transistor des surtensions qui peuvent être destructrices pour le composant, tout en utilisant un oscillateur OSC à fréquence fixe pour délivrer le train d'impulsions de commande, ce qui permet d'éviter la prise en compte de stratégies compliquées de commandes et de gestion de durée de la première impulsion, il est prévu d'adjoindre dans cet exemple une diode ZENER D1 aux bornes du transistor de commutation M1.

Plus précisément, dans l'exemple décrit dans lequel une première électrode de conduction (ici le drain) est connecté au résonateur inductif capacitif L2C2, la cathode de la diode Zener D1 est connectée à cette première électrode de conduction (drain D) tandis que l'anode de la diode Zener est connectée à l'autre électrode de conduction (ici la source S), qui est par ailleurs elle-même connectée à la masse.

La tension aux bornes drain source du transistor de puissance M1 est alors limité et égal à la tension Zener de la diode.

Ainsi, la tension aux bornes drain source du transistor ne dépasse pas la valeur de claquage.

## Revendications

1. Dispositif de génération de plasma, comprenant une bougie de génération de plasma (BR) contenant un résonateur inductif capacitif (RS2) apte à produire une haute tension, des moyens de génération d'un train d'impulsions de commande haute fréquence, et un générateur de tension (GENI) comprenant un transistor de commutation (M1) dont l'électrode de commande est reliée à la sortie des moyens de génération et une sortie apte à délivrer un train d'impulsions de tension au résonateur en réponse au train d'impulsions de commande reçues sur l'électrode de commande du transistor de commutation, **caractérisé par le fait qu'**il comprend en outre des moyens (D1) connectés entre les deux électrodes de conduction du transistor de commutation et aptes à limiter la différence de tension entres ces deux autres électrodes.

2. Dispositif selon la revendication 1, dans lequel lesdits moyens de limitation de tension comprennent une diode Zener (D1).

3. Dispositif selon la revendication 2, dans lequel le transistor de commutation (M1) est un transistor MOSFET dont une première électrode de conduction est connectée au résonateur inductif capacitif, et la cathode de la diode Zener (D1) est connectée à ladite première électrode de conduction, l'anode de la diode Zener étant connectée à l'autre électrode de conduction.

4. Dispositif selon l'une des revendications précédentes, dans lequel les moyens de génération du train d'impulsions de commande comprennent un oscillateur à fréquence fixe (OSC).

## Patentansprüche

1. Plasmaerzeugungsvorrichtung, umfassend eine Erzeugungssonde für Plasma (BR), einen kapazitiven induktiven Resonator (RS2) aufweisend, der in der Lage ist, eine Hochspannung zu produzieren, Erzeugungsmittel einer Steuerimpulskette hoher Frequenz, und einen Spannungsgenerator (GENI), der einen Schaltungstransistor (M1), dessen Steuerelektrode mit dem Ausgang der Erzeugungsmittel verbunden ist, und einen Ausgang umfasst, der in der Lage ist, eine Spannungsimpulskette an dem Resonator als Reaktion auf die Steuerimpulskette zu liefern, die an der Steuerungselektrode des Schaltungstransistors empfangen wird, **dadurch gekennzeichnet, dass** sie außerdem Mittel (DI) umfasst, die zwischen den beiden Leitungselektroden des Schaltungstransistors verbunden sind und die in der Lage sind, die Spannungsdifferenz zwischen diesen beiden anderen Elektroden zu begrenzen.

2. Vorrichtung nach Anspruch 1, wobei die Spannungsbegrenzungsmittel eine Zenerdiode (D1) umfassen.

3. Vorrichtung nach Anspruch 2, wobei es sich bei dem Schaltungstransistor (M1) um einen MOSFET-Transistor handelt, dessen erste Leitungselektrode mit dem kapazitiven induktiven Resonator verbunden ist, und die Kathode der Zenerdiode (D1) mit der ersten Leitungselektrode verbunden ist, wobei die Anode der Zenerdiode mit der anderen Leitungselektrode verbunden ist.

4. Vorrichtung nach einem der vorhergehenden Ansprüche, wobei die Erzeugungsmittel der Steuerungsimpulskette einen Oszillator mit fester Frequenz (OSC) umfassen.

## Claims

1. Device for generating plasma, comprising a plasma-generating spark plug (BR) containing an LC resonator (RS2) able to produce a high voltage, means for generating a high-frequency control pulse train, and a voltage generator (GENI) comprising a switching transistor (M1) the control electrode of which is connected to the output of the generating means and an output of which is able to deliver a voltage pulse train to the resonator in response to the control pulse train received on the control electrode of the switching transistor, **characterized in that** it furthermore comprises means (D1) connected between the two conduction electrodes of the switching transistor and able to limit the voltage difference between these two other electrodes.

2. Device according to Claim 1, wherein said voltage-limiting means comprise a Zener diode (D1).

3. Device according to Claim 2, wherein the switching transistor (M1) is a MOSFET transistor a first conduction electrode of which is connected to the LC resonator, and the cathode of the Zener diode (D1) is connected to said first conduction electrode, the anode of the Zener diode being connected to the other conduction electrode.

4. Device according to one of the preceding claims, wherein the means for generating the control pulse train comprise a fixed frequency oscillator (OSC).
